# EUROPEAN PATENT SPECIFICATION

(11) **EP 2 112 598 B1**
(45) Date of publication and mention of the grant of the patent: **16.11.2011**
(21) Application number: 09000724.6
(22) Date of filing: 20.01.2009
(51) Int. Cl.: G06F 11/07, G06F 12/02

(54) **Storage system**
Speichersystem
Système de stockage

(30) Priority: 25.04.2008 JP 2008114773
(43) Date of publication of application: 28.10.2009
(73) Proprietor: Hitachi, Ltd., Tokyo 100-8280 (JP)
(72) Inventor: Sugimoto, Sadahiro c/o Hitachi, Ltd., Intellectual Property Group, Tokyo 100-8220 (JP); Yamamoto, Akira c/o Hitachi, Ltd., Intellectual Property Group, Tokyo 100-8220 (JP)
(74) Representative: Beetz & Partner

(56) References cited:
- EP-A- 1 768 014
- US-A1- 2008 005 530
- US-A1- 2008 082 736

## Description

### CROSS-REFERENCE TO PRIOR APPLICATION

This application relates to and claims the benefit of priority from Japanese Patent Application number 2008-114773, filed on April 25, 2008.

### BACKGROUND

The present invention generally relates to a storage system, and more particularly to a storage system that uses a nonvolatile semiconductor memory such as a flash memory.

Storage devices that use flash memory and other such nonvolatile semiconductor memory in place of conventional hard disk devices have been attracting attention in recent years. Compared to a hard disk, a flash memory has the advantages of being able to operate at high speed and consuming less power, but, on the other hand, flash memory also has the following restrictions. First, the updating of the respective bits of memory is limited to one direction, that is, from '1' to '0' (or from '0' to '1'). When a reverse change is required, it is necessary to delete a memory block (hereinafter called the "block") and make the entire block `1's (or `0's) one time. Further, there is a limit to the number of times this deletion operation can be carried out, and in the case of a NAND-type flash memory, for example, this limit is somewhere between 10,000 and 100,000 times.

Thus, connecting a flash memory to a computer in place of a hard disk device runs the risk of the write frequency bias of each block resulting in only a portion of the blocks reaching the limit for number of deletions and becoming unusable. For example, since the blocks allocated to the directory or inode have a higher rewrite frequency than the other blocks in an ordinary file system, there is a high likelihood that only these blocks will reach the limit for number of deletions.

With regard to this problem, a technique that extends the life of a storage device by allocating an alternate memory area (alternate block) to a memory area that has become unusable (a bad block) as disclosed in Japanese Patent Laid-open No. 5-204561 is known.

The document US 2008/0082736 Al teaches a memory controller writing data to a randomly chosen free block if a bad block is recognized in order to achieve wear-leveling of the different physical storage blocks.

### SUMMARY

However, applying the technique disclosed in Japanese Patent Laid-open No. 5-204561 does not make it possible to extend the life of a storage device indefinitely, and when the memory areas, which were provided beforehand in the storage device, and which are capable of being allocated as alternate blocks run out, the storage device will reach the end of its service life.

When configuring a storage system using a storage device that makes use of a flash memory like this in place of a hard disk, a storage device that has reached the end of its service like must be replaced with a new storage device. Because of the bias in the frequency of writes from the host computer, it can be assumed that a large number of usable blocks remain in a storage device that has reached the end of its life, but these usable blocks are discarded at replacement time, resulting in this portion of the flash memory capacity being wasted. Furthermore, the need to replace a semiconductor disk can be eliminated by mounting beforehand in the storage device the maximum amount of spare blocks capable of being used as alternate blocks while the storage system is in operation, but in addition to the increase in initial costs, the concern is that these spare blocks will not be completely used up during actual operation, and thus become a waste.

Therefore an object of the present invention is to reduce the waste described hereinabove.
This object can be achieved by a storage system according to claim 1.

The storage system has a storage controller, and a flash memory module that is coupled to the storage controller. The storage controller manages the status of the storage area in a flash memory chip of the flash memory module. When it becomes impossible to write to a portion of the storage area in the flash memory chip, the storage controller exercises control such that a free storage area is used as an alternate area for a storage area that has become unwritable, and the data stored in the unwritable storage area is stored in the alternate area.

### BRIEF DESCRIPTION OF THE DRAWINGS

Fig. 1 is a diagram showing an example-of the configuration of a storage system;
Fig. 2 is a diagram showing an example of block management information in a first embodiment;
Fig. 3 is a diagram showing an example of an alternate block allocation method of the first embodiment;
Fig. 4 is a diagram showing an example of a management server GUI of the first embodiment;
Fig. 5 is a flowchart showing an example of a process in which the management server of the first embodiment checks the free block capacity in the storage system, and displays a warning message;
Fig. 6 is a flowchart showing an example of a process in which a microprocessor of a storage device of the first embodiment checks the free block capacity and sends a warning message to the management server;
Fig. 7 is a conceptual view showing an example of a RAID1 configuration in a second embodiment;
Fig. 8 is a diagram showing an example of an alternate block allocation method of the second embodiment;
Fig. 9 is a diagram showing an example of a management server GUI of the second embodiment;
Fig. 10 is a diagram showing an example of block management information in the second embodiment;
Fig. 11 is a flowchart showing an example of a destage process of the second embodiment;

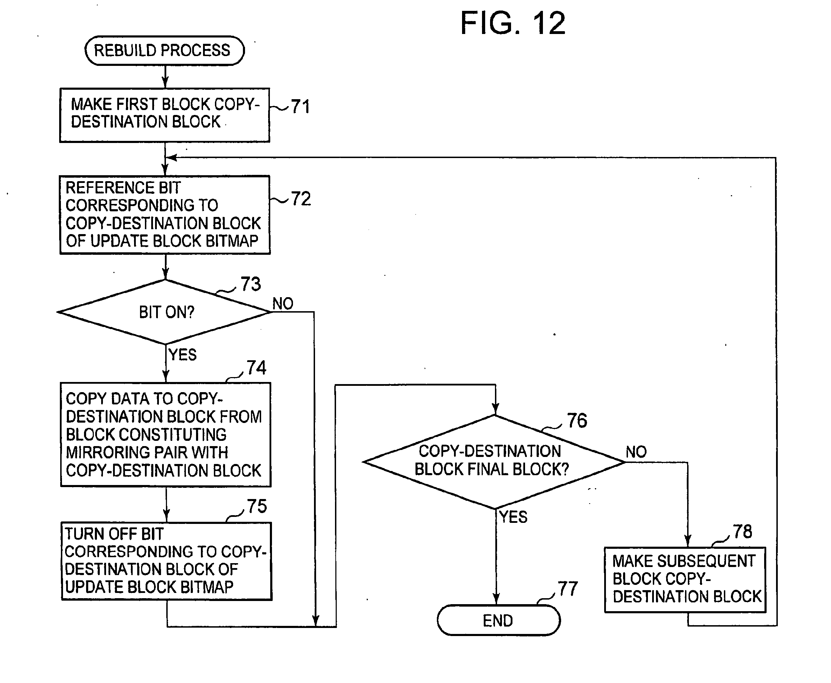

Fig. 12 is a flowchart showing an example of a rebuild process of the second embodiment; and
Fig. 13 is a conceptual view showing an example of a RAID5 configuration.

### DESCRIPTION OF THE PREFERRED EMBODIMENTS

An example of an embodiment of the present invention will be explained below while referring to the figures.

### [Embodiment 1]

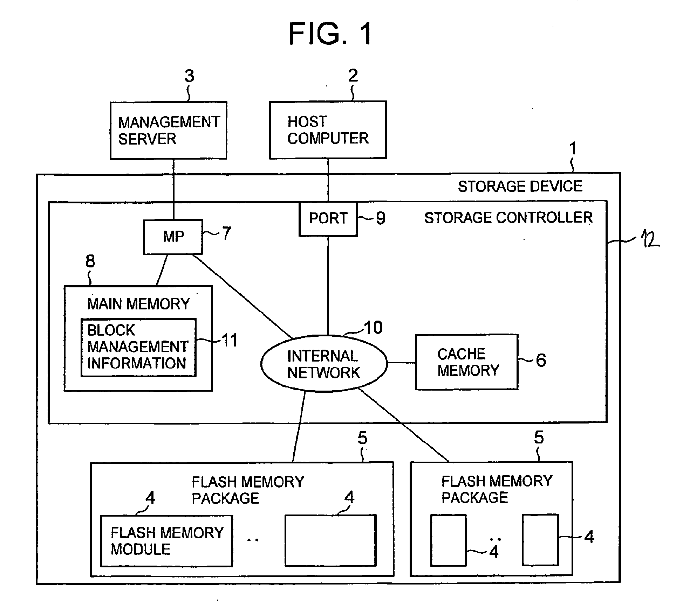

Fig. 1 is a diagram showing an example of the configuration of a storage system.

The storage system 1, for example, is a storage device comprising a plurality of flash memory modules. A host computer 2, which is one type of higher-level device, and which issues an I/O request, and a management server 3, which is a computer for managing the storage system 1, are coupled to the storage system 1. The storage system 1 has a plurality of flash memory modules 4 that store storage controllers and data; and one or a plurality of flash memory packages 5 capable of mounting a plurality of flash memory modules. The storage controller 12 comprises a cache memory 6, which is a memory for caching data; one or more microprocessors (hereinafter notated as MP) 7 for controlling the storage system 1; a main memory 8 that holds data and programs for carrying out control; one or more ports 9 for exchanging data with the host computer 2; and an internal network 10 that interconnects the flash memory package 5, cache memory 6, port 9 and MP 7.

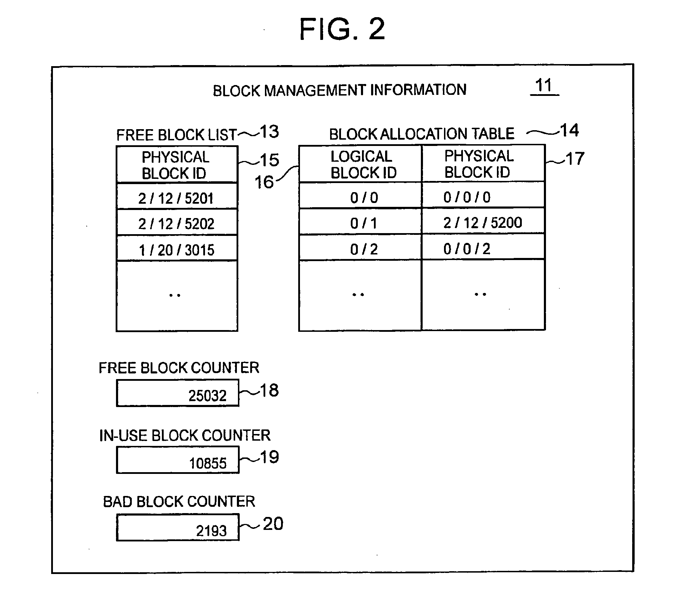

The flash memory module, for example, is a memory module, which is shaped like a DIMM (Dual Inline Memory Module), and which mounts a plurality of flash memory chips on a printed circuit board. Further, the flash memory package 5, for example, is a substrate comprising one or more slots for connecting a flash memory module 4; a control unit (LSI) for controlling access to a flash memory chip in the flash memory module 4; and a connector for connecting to the internal network 10 of the storage system. The main memory 8 stores block management information 11 for managing at least the blocks of a flash memory. An example of block management information 11 is shown in Fig. 2.

The block management information 11 comprises a free block list 13; block allocation table 14; free block counter 18; in-use block counter 19; and bad block counter 20. An in-use block here is one that is allocated as a data storage area, and comprises an alternate block. Further, a bad block is a block that has reached the limit for number of deletions, and is a block that cannot be used for fear of causing other failures. Furthermore, data cannot be written to a block that has reached the limit for number of deletions and has become of bad block, but it is possible to read data from this block. A free block is a block other than the ones just described, that is, a free block is one that is usable and, in addition, is not being used.

The free block list 13 lists up the physical block IDs 15 of free blocks. The physical block ID 15 is an identifier for uniquely specifying a block in the storage system, and, for example, is expressed as a combination of a flash memory package number, a flash memory module number in the flash memory package, and a block number in the flash memory module.

The block allocation table 14 is a mapping table of logical block IDs 16 that denotes the location of blocks in a logical address space, and the physical block IDs 17 of the blocks allocated to this logical block. The logical block ID 16, for example, is a combination of a device number and a block number in the device. The in-device block number, for example, is the quotient arrived at by dividing the addresses in the device by the block size.

The free block counter 18, in-use block counter 19 and bad block counter 20 are counters for respectively storing the number of free blocks, the number of used blocks, and the number of bad blocks in the storage system.

For example, when a block is allocated anew as a data storage area, the MP7 decrements the free block counter 18 by 1, and increments the in-use block counter 19 by 1. Further, when one.block becomes unusable, and a free block is allocated as an alternate block, the MP7 increments the bad block counter 20 by 1 and decrements the free block counter 18 by 1.

Next, the alternate block allocation method will be described. In this embodiment, when a bad block occurs, the storage controller allocates a free block as an alternate block, and when data had been stored in the original block, which became a bad block, the storage controller moves this data to the alternate block. Furthermore, when a bad block occurs due to a failure, it may not be possible to read the data from the original block. In this case, for example, when a RAID (Redundant Arrays of Independent Disks) configuration is employed, the storage controller can use data and parity stored in another flash memory or magnetic disk to restore the data stored in the original block and write this data to the alternate block. Further, if it is backup data, the storage controller can copy the backup data to the alternate block. A configuration, which uses a plurality of flash memory packages 5 and forms a RAID configuration, will given as an example of the configuration of a second embodiment further below.

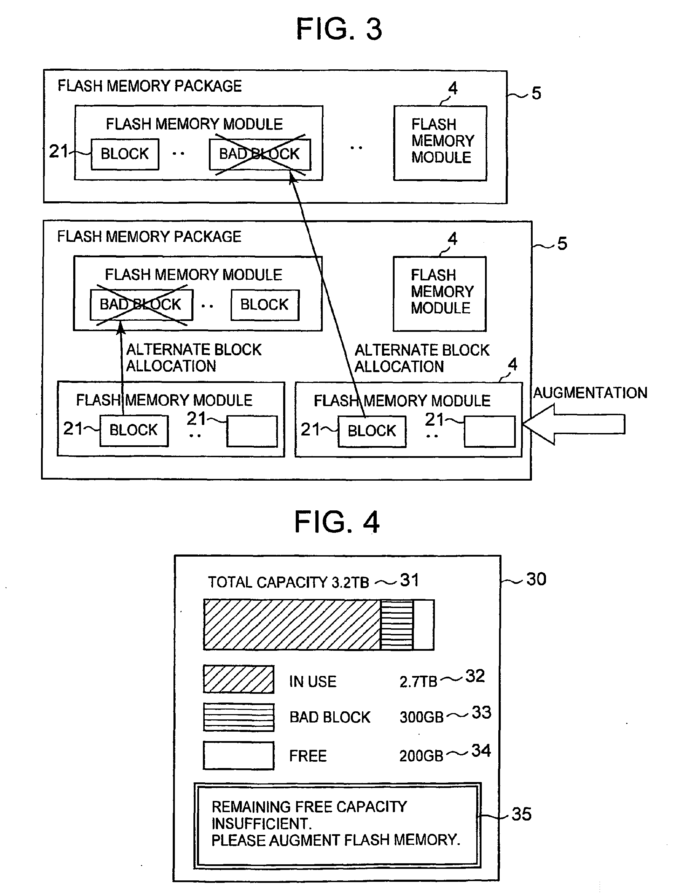

In this embodiment, since control of all the flash memories in the storage system is carried out by the MP7 of the main storage device, as shown in Fig. 3, it becomes possible to allocate an arbitrary free block in the storage system as an alternate block. That is, like the example disclosed in Fig. 3, a block in a flash memory module that differs from the flash memory module to which the bad block belongs can be used as the alternate block, and a block in a flash memory module connected to a flash memory package that differs from the flash memory package connected to the flash memory module to which the bad block belongs can be used as the alternate block. Although not shown in the figure, an alternate block can also be selected from inside the flash memory module to which the bad block belongs. Furthermore, when a flash memory module 4 is augmented, the MP7 registers the block of the augmented flash memory module in the free block list 13, and increases the value of the free block counter 18 by the number of blocks that were added. Thereafter, when allocating an alternate block, a block registered in the free block list 13 can be allocated. Next, managing the free block capacity will be explained.

When there are no more free blocks in the storage system, it becomes impossible to allocate a free block as an alternate block when a bad block occurs. Accordingly, the MP7 manages the free block capacity in the system, issues a warning when the remaining free block capacity is insufficient, and urges the administrator to augment flash memory.

Fig. 4 is an example of a GUI (Graphical User Interface) for managing the flash memory capacity in the storage system.

This GUI respectively displays the total capacity 31 of the flash memory mounted in the storage system 1; the total capacity 32 of the data-storing blocks (used) thereamong; the total capacity of the bad blocks 33; and the total capacity of the free blocks (free capacity) 34. Then, when the free capacity becomes insufficient, the GUI displays a message to that effect as a warning message in the message display area 35. Furthermore, means for issuing a warning are not limited to a warning message, and, for example, electronic mail or a syslog can also be used.

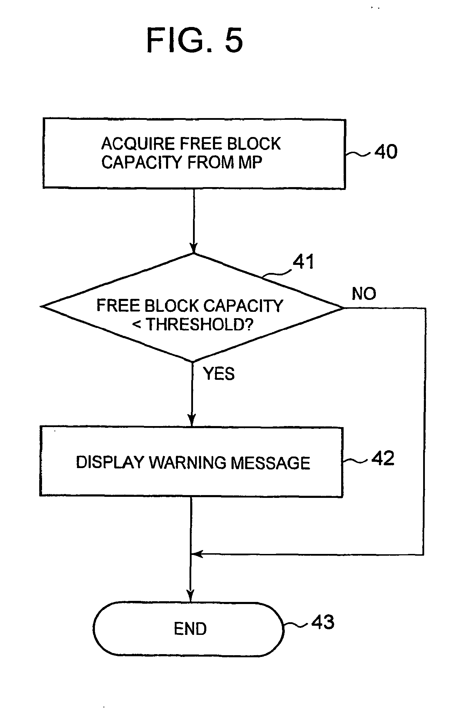

Next, Fig. 5 shows an example of a process in which the management server 3 checks the free block capacity 34 in the storage system, and displays a warning message. First, the management server 3 acquires the free block capacity 34 in the storage system from the MP7 (Step 40). Next, the management server 3 determines whether or not the free block capacity 34 is smaller than a predetermined threshold (Step 41). When the result of this determination is that the free block capacity 34 is smaller than the threshold, the management server 3 displays a warning message (Step 42), and ends processing (Step 43). When the free block capacity 34 is not smaller than the threshold (that is, when the free block capacity 34 is the threshold or greater), the management server 3 ends processing as-is.

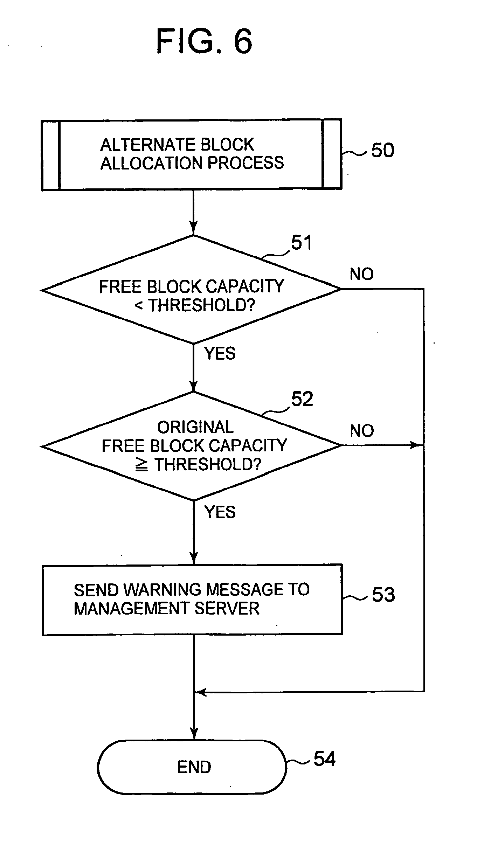

Furthermore, for example, a configuration in which the MP7 of the storage device independently checks the free block capacity 34, and sends a warning message to the management server 3 can also be used. The flowchart of Fig. 6 shows an example of the processing at that time. The MP7, after carrying out an alternate block allocation process (Step 50), determines whether or not the free block capacity 34 is smaller than the threshold (Step 51). When the free block capacity 34 is smaller than the threshold, the MP7 determines whether or not the free block capacity 34 was the threshold or greater prior to the alternate block allocation process (Step 52), and if this is true, sends a warning message to the management server 3 (Step 53). Furthermore, Step 52 is a determination for preventing the warning message from being sent repeatedly.

### [Embodiment 2]

A second embodiment of the present invention will be explained next.

The configuration of the storage system 1 in this embodiment is the same as in the first embodiment, and an example of this configuration is shown in Fig. 1.

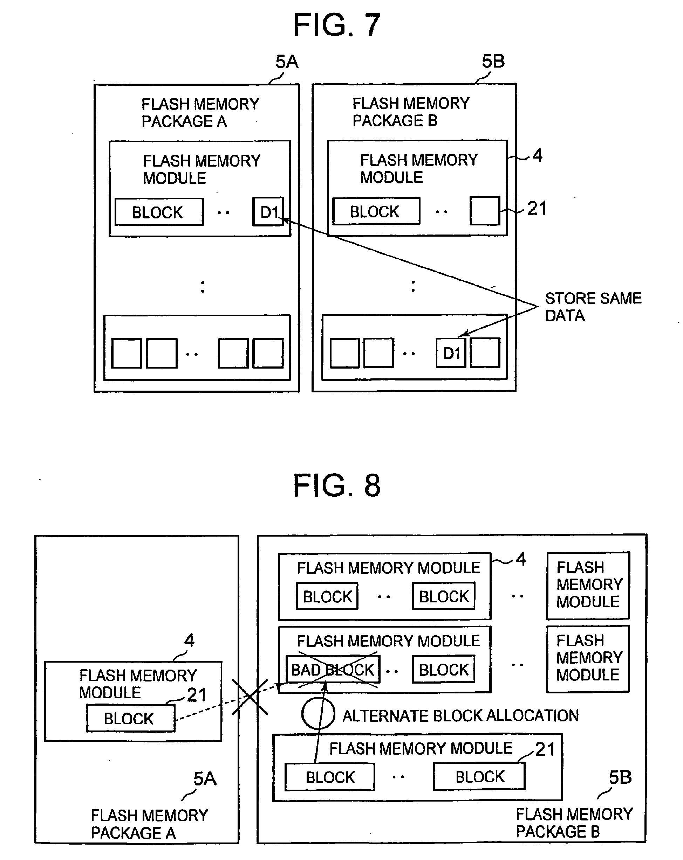

As described for the first embodiment, the allocation of an alternate block for the storage system 1 can be carried out for an arbitrary block in the storage system 1, but in this embodiment, the alternate block allocation range is limited to improve the reliability of the system. As one example, a case in which a plurality of flash memory packages 5 are configured into a RAID system in preparation for a flash memory package 5 failure will be considered. As an example, it is supposed here that two flash memory packages 5 are used, and that a RAID1 (mirroring) configuration, which stores the same data in two blocks in different flash memory packages 5, is formed as in Fig. 7.

In this case, since the redundancy for package failure is lost when the two blocks that store the same data constituting the mirror pair are arranged in the same package, when allocating an alternate block to a certain block, a free block in the same package as the original block is allocated as the alternate block as in Fig. 8.

As described hereinabove, the alternate block allocation range is limited in this embodiment, but since an alternate block can be allocated between flash memory modules 4, the augmentation units, a usable block can continue to be used as-is even when bad blocks increase and a flash memory module is augmented, achieving the efficient use of flash memory capacity effect in this embodiment as well.

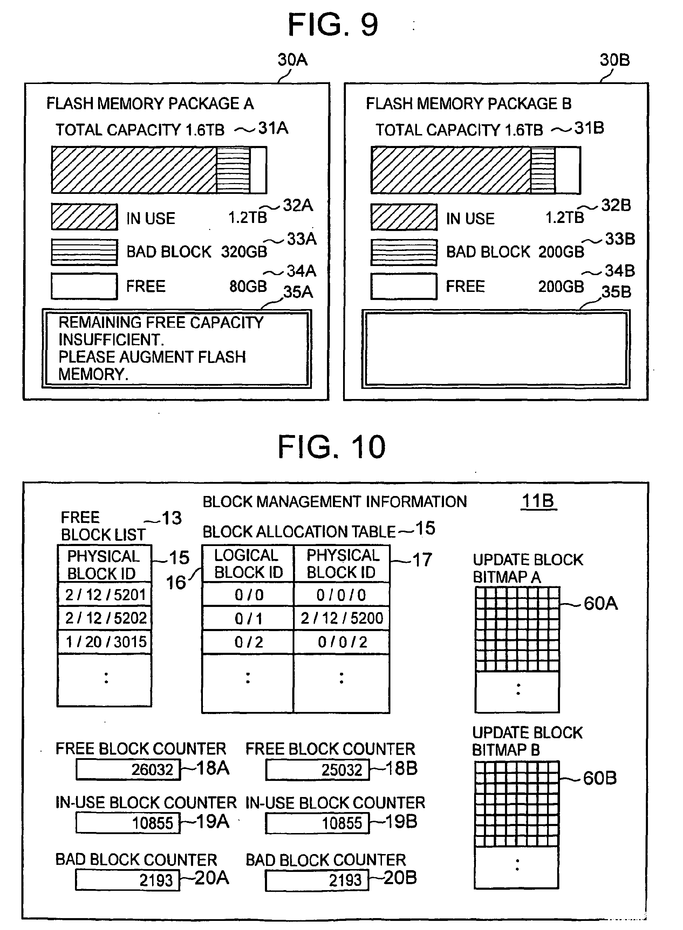

Fig. 9 shows an example of a GUI of this embodiment. Since the allocation of an alternate block is limited to the inside of the flash memory package, the management of flash memory capacity is carried out by each flash memory package. Then, the warning message when the remaining free block capacity becomes insufficient is outputted for each flash memory package. In Fig. 9, since the remaining free block capacity 34A in flash memory package A has become insufficient, a warning message is displayed in the message display area 35A.

Furthermore, in this embodiment, it is possible to remove the flash memory packages 5 one by one from the storage device, and to augment the flash memory modules 4 in the flash memory packages 5 while the system is in operation.

For example, when augmenting a flash memory module 4 in flash memory package A (5A), if a read command targeting an address corresponding to data D1 is received from the host computer 2 while blocking and removing the flash memory package A (5A) from the storage device, the MP7 can read the data D1 in flash memory package B (5B) and send this data D1 to the host computer 2. Further, when a write command targeting an address corresponding to data D1 is received from the host computer 2, and this data D1 is written to flash memory, the MP7 can update the data D1 in flash memory package B (5B) using the data received from the host computer 2. Then, when memory module augmentation ends, and flash memory package A (5A) is reinstalled in the storage device, the MP7 can copy the data of the respective blocks in flash memory package B (5B) to blocks that constitute the mirror pairs in flash memory package A (5A), that is, the MP7 can execute a rebuild process.

Furthermore, since the original data remains in flash memory package A (5A) at this time, it is not always necessary to rebuild flash memory package A (5A) in its entirety. For example, the MP7 can shorten rebuild time by using a bitmap or the like to record blocks corresponding to addresses for which a write has been carried out during flash memory augmentation, and then only rebuilding these blocks. Fig. 10 shows an example of block management information 11B, which adds an update block bitmap showing the presence or absence of a write to the respective blocks. Update block bitmap A (60A) is the update block bitmap for flash memory package A, and update block bitmap B (60B) is the update block bitmap for flash memory package B. Furthermore, different counters are used in flash memory package A and flash memory package B for the free block counter 18, in-use block counter 19 and bad block counter 20.

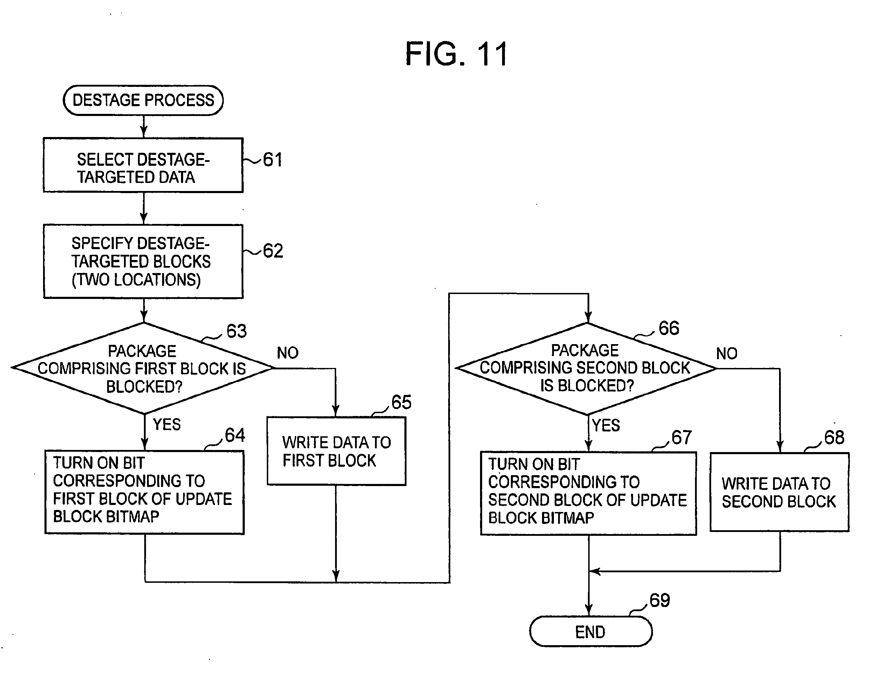

Fig. 11 shows a flowchart of a data write process to flash memory (destage process) comprising a process for recording an update location in this update block bitmap. First, the MP7 selects the data targeted for destaging (Step 61). Next, MP7 uses the block allocation table 14 to specify the physical blocks ID of the destage-targeted blocks (two locations) where data is to be stored from the destage-destination device numbers and addresses (Step 62).

Next, the MP7 determines whether or not the package comprising the first destage-targeted block is blocked (Step 63), and if this package is blocked, turns ON the bits corresponding to the first block of the update block bitmap (Step 64). If this package is not blocked, the MP7 writes the data to the first block (Step 65).

Next, the MP7 determines whether or not the package comprising the second destage-targeted block is blocked (Step 66), and if this package is blocked, turns ON the bits corresponding to the second block of the update block bitmap (Step 67). If this package is not blocked, the MP7 writes the data to the second block (Step 68).

Fig: 12 is a flowchart of a rebuild process that uses the update block bitmap. First, the MP7 sets the first block comprised in the flash memory package that was augmented as the copy-destination block (Step 71). Then, the MP7 references the bit of the update block bitmap corresponding to the copy-destination block (Step 72). Next, the MP7 determines whether or not this bit is ON (Step 73), and if the bit is ON, the MP7 copies data to the copy-destination block from the block that constitutes the mirror pair relative to the copy-destination block (Step 74), and turns OFF the bit of the update block bitmap corresponding to the copy-destination block (Step 75). If the bit is OFF, the MP7 skips Step 74 and Step 75, and proceeds to Step 76. Next, the MP7 determines whether or not the current copy-destination block is the final block in the flash memory package (Step 76), and if the copy-destination block is the final block, ends the rebuild process (Step 77). If the copy-destination block is not the final block in the flash memory package, the MP7 sets the subsequent block as the copy-destination block (Step 78), returns to Step 72, and continues processing.

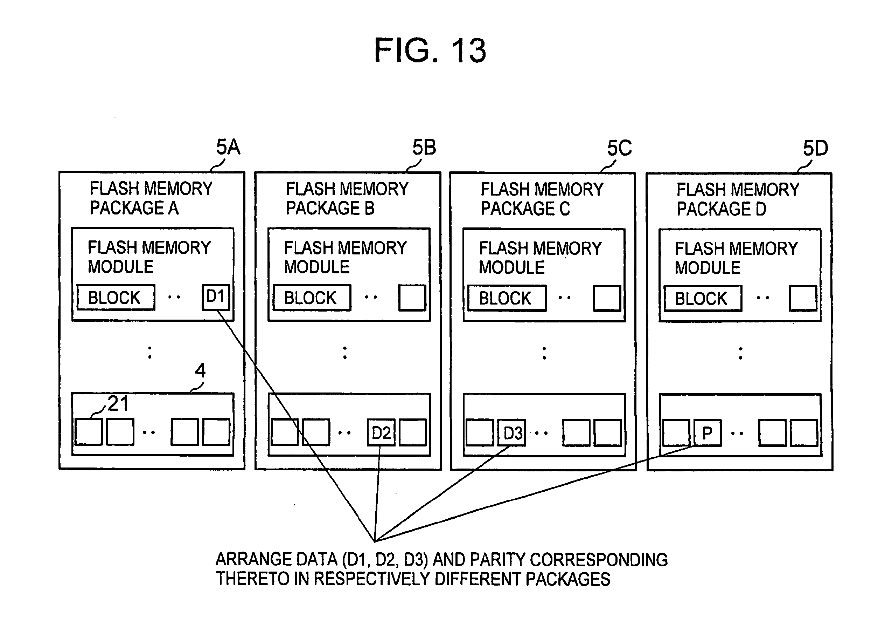

The preceding has described this embodiment in the case of RAID1, but the embodiments of the present invention are not limited to this, and, for example, can also utilize other RAID configurations such as RAID5, RAID6, and so on. For example, in the case of a RAID5 (3D + 1P), data (D1, D2, D3) and the parity (P) corresponding thereto can be arranged in respectively different flash memory packages as in Fig. 13. Naturally, when carrying out a rebuild process, or when a read or write has been received from the host, unlike in RAID1, the data and parity are created using a parity operation.

Further, in this embodiment, a flash memory package is given as an example of an alternate block allocation range, but the embodiments of the present invention are not limited to this. Redundancy should be better than when the entire storage system is used as the allocation range, so the storage controller can split the storage system into a plurality of partitions using an arbitrary condition, and the allocation of an alternate block can be restricted solely to the inside of a partition. For example, it is also possible to set the scope of the power source boundary or storage device enclosure as the alternate block allocation range (that is, the partition).

Furthermore, in the first and second embodiments, the configuration is such that flash memory modules 4 are mounted in a flash memory package to facilitate the augmentation of flash memory in the storage system, but the embodiments of the present invention are not limited to this, and, for example, a configuration that stores the substrate on which the flash memory chip is mounted in a box-shaped memory cartridge, and connects this memory cartridge to the storage device can also be used.

In addition, in the first and second embodiments, cache memory 6 and main memory 8 are different memories, but the embodiments of the present invention are not limited to this, and, for example, data written in from the host, a program and control data can also be stored in the same memory.

## Claims

1. A storage system, comprising:
- a storage controller (12);
- a plurality of flash memory modules (4) coupled to the storage controller (12),
- a plurality of flash memory packages (5) each having a connector which is coupled to the storage controller (12) and is coupled to any of the plurality of flash memory modules (4), and
- a control unit (LSI) that controls access to a flash memory chip in a flash memory module (4), which is connected via the connector, and
wherein:
- the controller includes a cache memory storing data written to/read from any one of the plurality of flash memory modules,
- the plurality of flash memory modules (4) each have one or a plurality of flash memory chips,
- the storage controller (12) manages the status of a storage area in a flash memory chip of the plurality of flash memory modules (4), and
- when a portion of a storage area in the flash memory chip of the plurality of flash memory modules becomes unwritable, the storage controller carries out control so as to use, as an alternate area for the portion of the storage area that has become unwritable, a free storage area from inside one of the flash memory chips of the plurality of flash memory modules (4), and to store data that has been stored in the portion of the storage area that has become unwritable, in the alternate area so as to configure a RAID group,
**characterized in that** the storage controller (12) is configured to carry out the following processes (A) to (F):
(A) using free storage areas of flash memory modules (4) coupled to respectively different flash memory packages (5) to configure the RAID group,
(B) selecting a free storage area as the alternate area from the free storage areas in the flash memory package which includes the portion of the storage area that has become unwritable,
(C) managing the number of free storage areas in each of the flash memory packages,
(D) outputting a warning message to add a new flash memory module to a predetermined flash memory package,selecting the alternate area from among the free storage areas in the new flash memory module (4) when finding that the number of free storage areas in said predetermined flash memory package is smaller than the threshold value,
(E) carrying out the following process (e1) to (e8) while a flash memory package is removed and another flash memory package is added,
(e1) selecting data targeted for destaging from the cache memory,
(e2) specifying a first and second destage-targeted storage areas where data is to be stored,
(e3) determining whether or not a first flash memory package comprising the first destage-targeted storage area is blocked,
(e4) turning ON a bit, if the first flash memory package is blocked, corresponding to the first storage area of a bitmap which includes a plurality of bits respectively corresponds to the plurality of storage areas,
(e5) writing the data to the first destage-targeted storage area, if the first flash memory package is not blocked,
(e6) determining whether or not a second flash memory package comprising the second destage-targeted storage area is blocked,
(e7) turning ON a bit, if the second flash memory package is blocked, corresponding to the second storage area of the bitmap,
(e8) writing the data to the second destage-targeted storage area, if the second flash memory package is not blocked,
(F) carrying out the following processes (f1) to (f5), after the another flash memory package has been added, each of the storage areas in the added flash memory package,
(f1) setting a storage area, as the copy-destination area,
(f2) referencing the bit of the block bitmap corresponding to the copy-destination area,
(f3) determining whether or not the referenced bit is ON,
(f4) copying data, if the referenced bit is ON, to the copy-destination area from the storage are that constitutes the mirror pair relative to the copy-destination area, and turning OFF the referenced bit of the bitmap corresponding to the copy-destination area,
(f5) determining whether or not the copy-destination area is the final area in the added flash memory package.

2. The storage system according to Claim 1, wherein the storage controller (12) has a memory (6) that records the status of the storage area in the flash memory chip of the plurality of flash memory modules (4), and
when the new flash memory module is coupled to the flash memory package, the storage controller acquires information showing the status.of.the storage areas in one or a plurality of flash memory chips of the new flash memory module (4), and stores the information in memory (6).

3. The storage system according to Claim 1, wherein the storage controller manages the total size of the free storage areas in the flash memory chip of the plurality of flash memory modules (4), and
when the total size satisfies a predetermined condition, the storage controller outputs a warning to add a new flash memory module (4) to the flash memory package.

4. The storage system according to Claim 1, wherein the storage controller selects a free area from among the storage areas that satisfy a predetermined condition, and uses the free area as the alternate area for the portion of the storage area that has become unwritable.

5. The storage system according to Claim 1, wherein the storage controller selects the alternate area from among the storage areas in the flash memory chip of the same flash memory module (4) as the portion of the storage area that has become unwritable.

6. The storage system according to Claim 1, wherein the storage controller (12) splits the storage area in the flash memory chips of the plurality of flash memory modules (4) into a plurality of partitions, and selects the alternate area from among the free storage areas belonging to the same partition as a partition to which the portion of the storage area that has become unwritable belongs.

7. The storage system according to Claim 6, wherein the storage controller manages the total size of the free storage areas in the partition for each partition.

8. The storage system according to Claim 1, wherein the storage controller is coupled to a management server(3), and
the storage controller manages the total size of the free storage areas in the flash memory chip of the plurality of flash memory modules (4), and outputs to the management server information showing the total size.

9. The storage system according to Claim 8, wherein the storage controller further manages the total size of the storage areas in use in the flash memory chip of the plurality of flash memory modules (4), and the total size of the storage areas that have become unwritable, and outputs to the management server (3) information showing the total size of the storage areas in use and the total size of the storage areas that have become unwritable.

## Patentansprüche

1. Speichersystem mit:
- einer Speichersteuerung (12);
- mehreren Flash-Speichermodulen (4), die mit der Speichersteuerung (12) gekoppelt sind,
- mehreren Flash-Speicherpaketen (5), die jeweils einen Verbinder aufweisen, der mit der Speichersteuerung (12) gekoppelt und mit irgendeinem der mehreren Flash-Speichermodule (4) gekoppelt ist, und
- einer Steuerungseinheit (LSI), die den Zugriff auf einen Flash-Speicherchip in einem Flash-Speichermodul (4) steuert, das über den Verbinder verbunden ist, und
wobei:
- die Steuerung einen Cachespeicher einschließt, der Daten speichert, die in die mehreren Flash-Speichermodule geschrieben/aus einem der mehreren Flash-Speichermodule gelesen werden,
- die mehreren Flash-Speichermodule (4) jeweils einen oder mehrere Flash-Speicherchips haben,
- die Speichersteuerung (12) den Status eines Speicherbereichs in einem Flash-Speicherchip der mehreren Flash-Speichermodule (4) verwaltet, und,
- wenn ein Abschnitt eines Speicherbereichs im Flash-Speicherchip der mehreren Flash-Speichermodule unbeschreibbar wird, die Speichersteuerung eine Steuerung so ausführt, dass sie als alternativen Bereich für den Abschnitt des Speicherbereichs, der unbeschreibbar geworden ist, einen freien Speicherbereich von innerhalb eines der Flash-Speicherchips der mehreren Flash-Speichermodule (4) verwendet und Daten, die in dem Abschnitt des Speicherbereichs gespeichert sind, der unbeschreibbar geworden ist, in dem alternativen Bereich speichert, um eine RAID-Gruppe zu konfigurieren,
**dadurch gekennzeichnet, dass** die Speichersteuerung (12) dazu konfiguriert ist, die folgenden Vorgänge (A) bis (F) auszuführen:
(A) Verwenden freier Speicherbereiche von Flash-Speichermodulen (4), die mit jeweils verschiedenen Flash-Speicherpaketen (5) gekoppelt sind, um die RAID-Gruppe zu konfigurieren,
(B) Auswählen eines freien Speicherbereichs als den alternativen Bereich aus den freien Speicherbereichen im Flash-Speicherpaket, der den Abschnitt des Speicherbereichs einschließt, der unbeschreibbar geworden ist,
(C) Verwalten der Anzahl freier Speicherbereiche in jedem der Flash-Speicherpakete,
(D) Ausgeben einer Warnmeldung, um ein neues Flash-Speichermodul zu einem vorgegebenen Flash-Speicherpaket hinzuzufügen, Auswählen des alternativen Bereichs unter den freien Speicherbereichen in dem neuen Flash-Speichermodul (4), wenn festgestellt wird, dass die Anzahl von freien Speicherbereichen in dem vorgegebenen Flash-Speicherpaket kleiner als der Schwellwert ist,
(E) Ausführen der folgende Vorgänge (e1) bis (e8), während ein Flash-Speicherpaket entfernt und ein anderes Flash-Speicherpaket hinzugefügt wird,
(e1) Auswählen von Daten, die zum Auslesen aus dem Cachespeicher anvisiert sind,
(e2) Spezifizieren eines ersten und zweiten zum Auslesen anvisierten Speicherbereichs, wo Daten gespeichert werden sollen,
(e3) Bestimmen, ob ein erstes Flash-Speicherpaket, das den ersten zum Auslesen anvisierten Speicherbereich umfasst, blockiert ist oder nicht,
(e4) AN-Schalten eines Bits, wenn das erste Flash-Speicherpaket blockiert ist, das dem ersten Speicherbereich einer Bitmap entspricht, die mehrere Bits einschließt, die jeweils den mehreren Speicherbereichen entsprechen,
(e5) Schreiben der Daten in den ersten zum Auslesen anvisierten Speicherbereich, wenn das erste Flash-Speicherpaket nicht blockiert ist,
(e6) Bestimmen, ob ein zweites Flash-Speicherpaket, das den zweiten zum Auslesen anvisierten Speicherbereich umfasst, blockiert ist oder nicht,
(e7) AN-Schalten eines Bits, wenn das zweite Flash-Speicherpaket blockiert ist, das dem zweiten Speicherbereich der Bitmap entspricht,
(e8) Schreiben der Daten in den zweiten zum Auslesen anvisierten Speicherbereich, wenn das zweite Flash-Speicherpaket nicht blockiert ist,
(F) Ausführen der folgenden Vorgänge (f1) bis (f5), nachdem das andere Flash-Speicherpaket hinzugefügt worden ist, jedem der Speicherbereiche in dem hinzugefügten Flash-Speicherpaket,
(f1) Einstellen eines Speicherbreichs als Kopie-Zielbereich,
(f2) Referenzieren des Bits der Blockbitmap, das dem Kopie-Zielbereich entspricht,
(f3) Bestimmen, ob das referenzierte Bit AN ist oder nicht,
(f4) Kopieren von Daten, wenn das referenzierte Bit AN ist, in den Kopie-Zielbereich aus dem Speicherbereich, der das Spiegelpaar relativ zu dem Kopie-Zielbereich bildet, und AUS-Schalten des referenzierten Bits der Bitmap, das dem Kopie-Zielbereich entspricht,
(f5) Bestimmen, ob der Kopie-Zielbereich der Schlussbereich in dem hinzugefügten Flash-Speicherbereich ist oder nicht.

2. Speichersystem nach Anspruch 1, wobei die Speichersteuerung (12) einen Speicher (6) aufweist, der den Status des Speicherbereichs im Flash-Speicherchip der mehreren Flash-Speichermodule (4) aufzeichnet, und wenn das neue Flash-Speichermodul mit dem Flash-Speicherpaket gekoppelt ist, erfasst die Speichersteuerung Informationen, die den Status der Speicherbereiche in einem oder mehreren Flash-Speicherchips des neuen Flash-Speichermoduls (4) zeigen, und speichert die Informationen im Speicher (6).

3. Speichersystem nach Anspruch 1, wobei die Speichersteuerung die Gesamtgröße der freien Speicherbereiche im Flash-Speicherchip der mehreren Flash-Speichermodule (4) verwaltet, und,
wenn die Gesamtgröße eine vorgegebene Bedingung erfüllt, gibt die Speichersteuerung eine Warnung aus, um ein neues Flash-Speichermodul (4) zum Flash-Speicherpaket hinzuzufügen.

4. Speichersystem nach Anspruch 1, wobei die Speichersteuerung einen freien Bereich unter den Speicherbereichen auswählt, die eine vorgegebene Bedingung erfüllen, und den freien Bereich als den alternativen Bereich für den Abschnitt des Speicherbereichs, der unbeschreibbar geworden ist, verwendet.

5. Speichersystem nach Anspruch 1, wobei die Speichersteuerung den alternativen Bereich unter den Speicherbereichen im Flash-Speicherchip desselben Flash-Speichermoduls (4) wie den Bereich des Speicherbereichs, der unbeschreibbar geworden ist, auswählt.

6. Speichersystem nach Anspruch 1, wobei die Speichersteuerung (12) den Speicherbereich in den Flash-Speicherchips der mehreren Flash-Speichermodule (4) in mehrere Unterteilungen spaltet und den alternativen Bereich unter den freien Speicherbereichen auswählt, die zu derselben Unterteilung wie eine Unterteilung gehören, zu welcher der Abschnitt des Speicherbereichs, der unbeschreibbar geworden ist, gehört.

7. Speichersystem nach Anspruch 6, wobei die Speichersteuerung die Gesamtgröße der freien Speicherbereiche in der Unterteilung für jede Unterteilung verwaltet.

8. Speichersystem nach Anspruch 1, wobei die Speichersteuerung mit einem Verwaltungsserver (3) gekoppelt ist, und
die Speichersteuerung die Gesamtgröße der freien Speicherbereiche im Flash-Speicherchip der mehreren Flash-Speichermodule (4) verwaltet und an den Verwaltungsserver Informationen ausgibt, die die Gesamtgröße zeigen.

9. Speichersystem nach Anspruch 8, wobei die Speichersteuerung weiterhin die Gesamtgröße der Speicherbereiche im Gebrauch im Flash-Speicherchip der mehreren Flash-Speichermodule (4) und die Gesamtgröße der Speicherbereiche, die unbeschreibbar geworden sind, verwaltet und an den Verwaltungsserver (3) Informationen ausgibt, die die Gesamtgröße der Speicherbereiche im Gebrauch und die Gesamtgröße der Speicherbereiche, die unbeschreibbar geworden sind, zeigen.

## Revendications

1. Système de stockage, comprenant :
- un contrôleur de stockage (12) ;
- une pluralité de modules de mémoire flash (4) couplés au contrôleur de stockage (12) ;
- une pluralité de boîtiers de mémoire flash (5) possédant chacun un connecteur qui est couplé au contrôleur de stockage (12) et qui est couplé à l'un quelconque des modules de mémoire flash (4), et
- une unité de contrôle (LSI) qui contrôle l'accès à une puce de mémoire flash dans un module de mémoire flash (4), qui est connecté via le connecteur, et
dans lequel :
- le contrôleur inclut une mémoire cache stockant des données écrites/lues dans l'un quelconque des modules de mémoire flash,
- la pluralité de modules de mémoire flash (4) possèdent chacun une ou plusieurs puces de mémoire flash,
- le contrôleur de stockage (12) gère le statut d'une zone de stockage dans une puce de mémoire flash de la pluralité de modules de mémoire flash (4), et
- quand une partie d'une zone de stockage dans la puce de mémoire flash de la pluralité de modules de mémoire flash devient non inscriptible, le contrôleur de stockage effectue un contrôle de manière à utiliser, comme zone alternative à la partie de la zone de stockage qui est devenue non inscriptible, une zone de stockage libre à l'intérieur de l'une des puces de mémoire flash de la pluralité de modules de mémoire flash (4) et à stocker les données qui ont été stockées dans la partie de la zone de stockage qui est devenue non inscriptible dans la zone alternative afin de configurer un groupe RAID,
**caractérisé en ce que** le contrôleur de stockage (12) est configuré pour réaliser les processus (A) à (F) suivants :
(A) utiliser les zones de stockage libres des modules de mémoire flash (4) couplés respectivement à différents boîtiers de mémoire flash (5) pour configurer le groupe RAID,
(B) sélectionner une zone de stockage libre comme zone alternative parmi les zones de stockage libres dans le boîtier de mémoire flash qui inclut la partie de la zone de stockage qui est devenue non inscriptible,
(C) gérer le nombre de zones de stockage libres dans chacun des boîtiers de mémoire flash,
(D) émettre un message d'avertissement pour ajouter un nouveau module de mémoire flash à un boîtier de mémoire flash déterminé au préalable et sélectionner la zone alternative parmi les zones de stockage libres dans le nouveau module de mémoire flash (4) lorsqu'il est constaté que le nombre de zones de stockage libres dans ledit boîtier de mémoire flash déterminé au préalable est inférieur à la valeur seuil,
(E) réaliser les processus (e1) à (e8) suivants lorsqu'un boîtier de mémoire flash est retiré et qu'un autre boîtier de mémoire flash est ajouté,
(e1) sélectionner les données destinées à être transférées à partir de la mémoire cache,
(e2) spécifier une première et une seconde zones de stockage destinées au transfert où les données doivent être stockées,
(e3) déterminer si un premier boîtier de mémoire flash comprenant la première zone de stockage destinée au transfert est bloqué ou non,
(e4) si le premier boîtier de mémoire flash est bloqué, activer un bit correspondant à la première zone de stockage d'un topogramme binaire qui inclut une pluralité de bits correspondant respectivement à la pluralité de zones de stockage,
(e5) si le premier boîtier de mémoire flash n'est pas bloqué, écrire les données dans la première zone de stockage destinée au transfert,
(e6) déterminer si un second boîtier de mémoire flash comprenant la seconde zone de stockage destinée au transfert est bloqué ou non,
(e7) si le second boîtier de mémoire flash est bloqué, activer un bit correspondant à la seconde zone de stockage du topogramme binaire,
(e8) si le second boîtier de mémoire flash n'est pas bloqué, écrire les données dans la seconde zone de stockage destinée au transfert,
(F) réaliser les processus (f1) à (f5) suivants, après que l'autre boîtier de mémoire flash ait été ajouté, en ce qui concerne chacune des zones de stockage dans le boîtier de mémoire flash ajouté,
(f1) déterminer une zone de stockage comme zone de destination de copie,
(f2) référencer le bit du topogramme binaire correspondant à la zone de destination de copie,
(f3) déterminer si le bit référencé est activé ou non,
(f4) si le bit référencé est activé, copier les données dans la zone de destination de copie à partir de la zone de stockage qui constitue un miroir par rapport à la zone de destination de copie, et désactiver le bit référencé du topogramme binaire correspondant à la zone de destination de copie,
(f5) déterminer si la zone de destination de copie est ou non la zone finale dans le boîtier de mémoire flash ajouté.

2. Le système de stockage selon la revendication 1, dans lequel le contrôleur de stockage (12) possède une mémoire (6) qui enregistre le statut de la zone de stockage dans la puce de mémoire flash de la pluralité de modules de mémoire flash (4), et quand le nouveau module de mémoire flash est couplé au boîtier de mémoire flash, le contrôleur de stockage acquiert des informations montrant le statut des zones de stockage dans une ou plusieurs puces de mémoire flash du nouveau module de mémoire flash (4), et stocke les informations dans la mémoire (6).

3. Le système de stockage selon la revendication 1, dans lequel le contrôleur de stockage gère la taille totale des zones de stockage libres dans la puce de mémoire flash de la pluralité de modules de mémoire flash (4), et
quand la taille totale satisfait à une condition déterminée au préalable, le contrôleur de stockage émet un avertissement pour ajouter un nouveau module de mémoire flash (4) au boîtier de mémoire flash.

4. Le système de stockage selon la revendication 1, dans lequel le contrôleur de stockage sélectionne une zone libre parmi les zones de stockage qui satisfont à une condition déterminée au préalable et utilise la zone libre comme zone alternative à la partie de la zone de stockage qui est devenue non inscriptible.

5. Le système de stockage selon la revendication 1, dans lequel le contrôleur de stockage sélectionne la zone alternative parmi les zones de stockage dans la puce de mémoire flash du même module de mémoire flash (4) que la partie de la zone de stockage qui est devenue non inscriptible.

6. Le système de stockage selon la revendication 1, dans lequel le contrôleur de stockage (12) divise la zone de stockage dans les puces de mémoire flash de la pluralité de modules de mémoire flash (4) en plusieurs partitions et sélectionne la zone alternative parmi les zones de stockage libres appartenant à la même partition qu'une partition à laquelle appartient la partie de la zone de stockage qui est devenue non inscriptible.

7. Le système de stockage selon la revendication 6, dans lequel le contrôleur de stockage gère la taille totale des zones de stockage libres dans la partition pour chaque partition.

8. Le système de stockage selon la revendication 1, dans lequel le contrôleur de stockage est couplé à un serveur de gestion (3), et
le contrôleur de stockage gère la taille totale des zones de stockage libres dans la puce de mémoire flash de la pluralité de modules de mémoire flash (4) et transmet au serveur de gestion les informations de serveur montrant la taille totale.

9. Le système de stockage selon la revendication 8, dans lequel le contrôleur de stockage gère en outre la taille totale des zones de stockage utilisées dans la puce de mémoire flash de la pluralité de modules de mémoire flash (4), et la taille totale des zones de stockage qui sont devenues non inscriptibles, et transmet au serveur de gestion (3) des informations montrant la taille totale des zones de stockage utilisées et la taille totale des zones de stockage qui sont devenues non inscriptibles.
